# EUROPEAN PATENT APPLICATION

(11) **EP 4 535 423 A2**
(43) Date of publication of application: **09.04.2025**
(21) Application number: 24200251.7
(22) Date of filing: 13.09.2024
(51) Int. Cl.: H01L 23/538, H01L 21/48, H01L 21/56, H01L 23/498, H01L 23/00, H01L 25/065, H01L 23/367, H01L 23/433

(54) **SEMICONDUCTOR PACKAGE STRUCTURE**

(30) Priority: 28.09.2023 US 202363585988 P; 02.07.2024 US 202418762183
(71) Applicant: MediaTek Inc., 30078 Hsinchu City (TW)
(72) Inventor: PENG, Tai-Hao, 30078 Hsinchu City (TW); HUANG, Yao-Tsung, 30078 Hsinchu City (TW)
(74) Representative: Haseltine Lake Kempner LLP

(57) **Abstract**

A semiconductor package structure includes a package substrate and a semiconductor die. The package substrate includes a core structure, a heat sink, and a redistribution layer. The heat sink is embedded in the core structure. The redistribution layer includes a thermal via disposed over the heat sink. The semiconductor die is disposed over the package substrate and is thermally coupled to the heat sink through the thermal via.

## Description

This application claims the benefit of U.S. Provisional Application No. 63/585,988 filed on September 28, 2023, the entirety of which is incorporated by reference herein.

### BACKGROUND OF THE INVENTION

### Field of the Invention

The present invention relates to semiconductor technology, and, in particular, to a semiconductor package structure that includes a heat sink.

### Description of the Related Art

In addition to providing a semiconductor die with protection from environmental contaminants, a semiconductor package structure can also provide an electrical connection between the semiconductor die packaged inside it and a substrate such as a printed circuit board (PCB).

Although existing semiconductor package structures generally meet requirements, they have not been satisfactory in all respects. For example, if the heat generated during the operation of a semiconductor die is not adequately removed, the increased temperatures may cause damage to the semiconductor components, and may cause thermal stress and warpage of the semiconductor package structure. However, some of the semiconductor components are not formed of materials with good thermal conductivity, which results in a low heat dissipation efficiency. Therefore, further improvements in semiconductor package structures are required.

### BRIEF SUMMARY OF THE INVENTION

Semiconductor package structures are provided. An exemplary embodiment of a semiconductor package structure includes a package substrate and a semiconductor die. The package substrate includes a core structure, a heat sink, and a redistribution layer. The heat sink is embedded in the core structure. The redistribution layer includes a thermal via disposed over the heat sink. The semiconductor die is disposed over the package substrate and is thermally coupled to the heat sink through the thermal via.

Another embodiment of a semiconductor package structure includes a first redistribution layer, a heat sink, a second redistribution layer, and a first semiconductor die. The heat sink is disposed over the first redistribution layer. The second redistribution layer is disposed over the heat sink and includes a thermal via. The first semiconductor die is disposed over the second redistribution layer and is thermally coupled to the heat sink through the first thermal via.

### BRIEF DESCRIPTION OF THE DRAWINGS

The present invention can be more fully understood by reading the subsequent detailed description and examples with references made to the accompanying drawings, wherein:
FIGs. 1A to 1G are cross-sectional views of various stages of manufacturing an exemplary semiconductor package structure in accordance with some embodiments of the present disclosure;
FIG. 2 is a cross-sectional view of an exemplary semiconductor package structure in accordance with some embodiments of the present disclosure;
FIG. 3 is a cross-sectional view of an exemplary semiconductor package structure in accordance with some embodiments of the present disclosure;
FIG. 4 is a top view of an exemplary semiconductor package structure in accordance with some embodiments of the present disclosure;
FIGs. 5A to 5E are cross-sectional views of various stages of manufacturing an exemplary semiconductor package structure in accordance with some embodiments of the present disclosure; and
FIG. 6 is a cross-sectional view of an exemplary semiconductor package structure in accordance with some embodiments of the present disclosure.

### DETAILED DESCRIPTION OF THE INVENTION

The following description is made for the purpose of illustrating the general principles of the invention and should not be taken in a limiting sense. The scope of the invention is best determined by reference to the appended claims.

The present disclosure will be described with respect to particular embodiments and with reference to certain drawings, but the disclosure is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the disclosure.

Additional elements may be added on the basis of the embodiments described below. For example, the description of "a first element on/over a second element" may include embodiments in which the first element is in direct contact with the second element, and may also include embodiments in which additional elements are disposed between the first element and the second element such that the first element and the second element are not in direct contact.

Furthermore, the description of "a first element extending through a second element" may include embodiments in which the first element is disposed in the second element and extends from a side of the second element to an opposite side of the second element, wherein a surface of the first element may be substantially leveled with a surface of the second element, or a surface of the first element may be outside a surface of the second element.

The spatially relative descriptors of the first element and the second element may change as the structure is operated or used in different orientations. In addition, the present disclosure may repeat reference numerals and/or letters in the various embodiments. This repetition is for simplicity and clarity and does not in itself dictate a relationship between the various embodiments discussed.

A semiconductor package structure including a heat sink is described in accordance with some embodiments of the present disclosure. The heat sink is adopted to replace semiconductor components which are not formed of good thermal conductivity materials, including a core structure of a package substrate, a molding material, or the like. As a result, the heat dissipation efficiency can be improved.

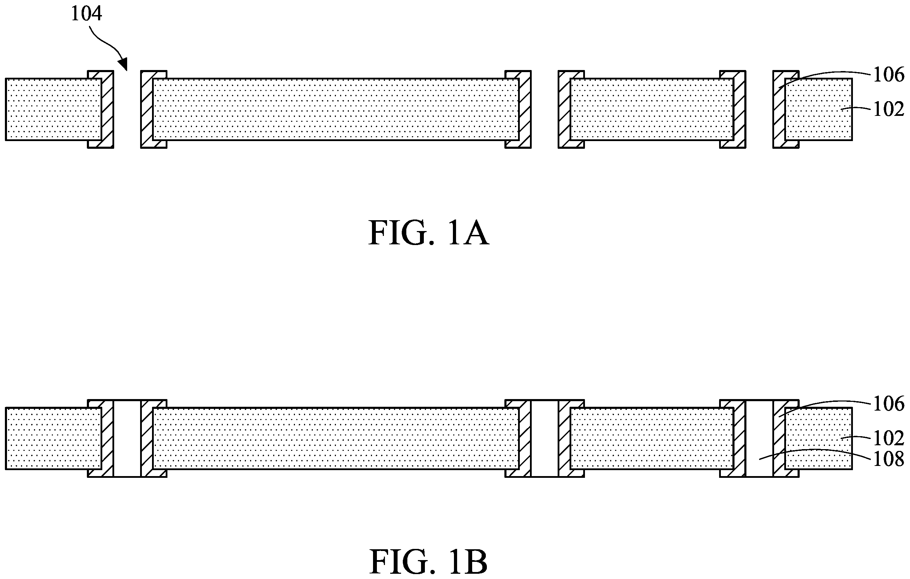

FIGs. 1A to 1G are cross-sectional views of various stages of manufacturing a semiconductor package structure 100 in accordance with some embodiments of the present disclosure. Additional features can be added to the semiconductor package structure 100. Some of the features described below can be replaced or eliminated for different embodiments. To simplify the diagram, only a portion of the semiconductor package structure 100 is illustrated.

As illustrated in FIG. 1A, a core structure 102 is provided, in accordance with some embodiments. The core structure 102 may be formed of an organic material, a glass material, a ceramic material, a semiconductor material, the like, or a combination thereof. The organic material may include fiberglass resin (e.g., FR4), bismaleimide triazine (BT) resin, the like, or a combination thereof. The semiconductor material may include silicon, germanium, or a compound material, including silicon germanium, silicon carbide, gallium arsenic, silicon germanium carbide, the like, or a combination thereof.

Then, a plurality of openings 104 are formed in the core structure 102, in accordance with some embodiments. The openings 104 may be formed through the core structure 102 by laser drilling or any suitable methods. Afterwards, a plurality of through vias 106 may be formed by plating at least sidewalls of the openings 104 with metal, such as copper, silver, gold, the like, an alloy thereof, or a combination thereof.

Then, as illustrated in FIG. 1B, a plurality of insulating plugs 108 are formed in each of the through vias 106, in accordance with some embodiments. The insulating plugs 108 may be formed by filling an insulating material such as resin in the space surrounded by the through vias 106, and then grinding to form a flat surface.

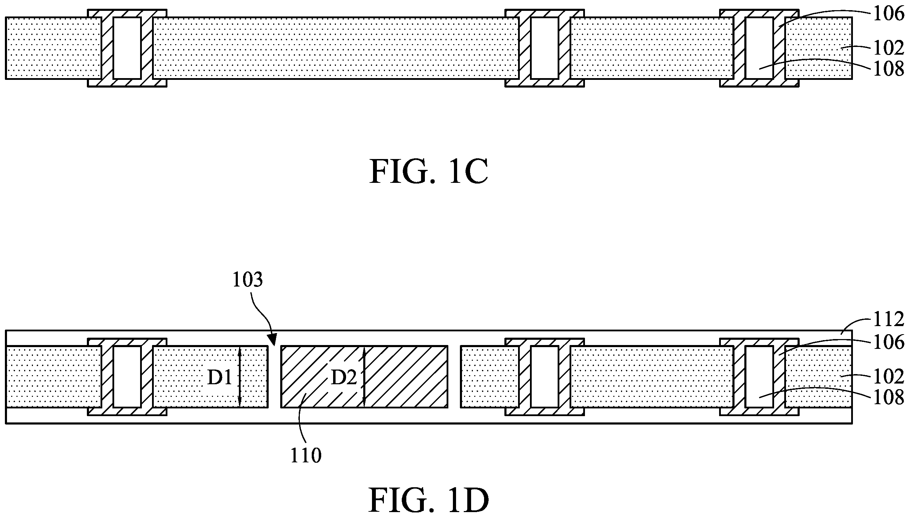

Afterwards, as illustrated in FIG. 1C, metal layers are formed on opposite surfaces of the insulating plugs 108 by plating or any suitable methods, in accordance with some embodiments. The metal layers may be formed of a material similar to that of the through vias 106, including copper, silver, gold, the like, an alloy thereof, or a combination thereof.

Then, as shown in FIG. 1D, a cavity 103 may be formed in the core structure 102 by laser drilling or any suitable methods. Afterwards, a heat sink 110 is disposed in the cavity 103, in accordance with some embodiments. The heat sink 110 may be embedded in the core structure 102 and thus may be referred to as an embedded heat sink. The heat sink 110 may be formed of high thermal conductivity and specific heat capacity material to provide more heat capacity. For example, the heat sink 110 may be formed of metal, including copper, silver, gold, the like, an alloy thereof, or a combination thereof.

As shown in FIG. 1D, the bottom surface of the core structure 102 may be substantially aligned with the bottom surface of the heat sink 110. The top surface of the core structure 102 may be substantially aligned with the top surface of the heat sink 110. The thickness D1 of the core structure 102 may be substantially equal to the thickness D2 of the heat sink 110. This allows subsequent layers (such as a redistribution layer) to be formed on flat surfaces.

Similarly, one or more active and passive devices (not shown) may also be disposed in the core structure 102 for the structural and functional requirements of the design. For example, the active and passive devices may include transistors, capacitors, resistors, the like, or a combination thereof.

Then, dielectric layers 112 are formed on opposite surfaces of the core structure 102 and fill in the space remaining in the cavity 103, in accordance with some embodiments. The dielectric layers 112 may extend between the core structure 102 and the heat sink 110 to space them apart. The dielectric layers 112 may be a build-up film, and may be formed of polymer or any suitable material.

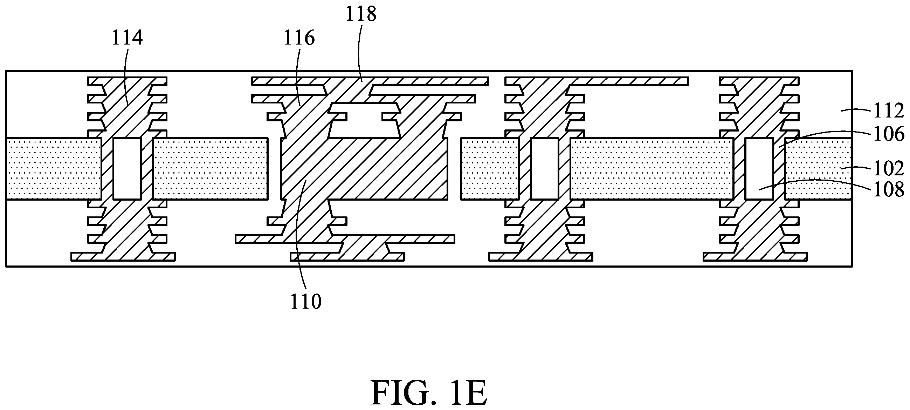

Afterwards, as shown in FIG. 1E, more dielectric layers 112 may be formed and patterned to form openings (not illustrated) therein. The openings may be through holes or trenches. Then, routing layers 114 may be formed in the openings. The routing layers 114 may include horizontal interconnects, such as conductive layers or conductive pads, and vertical interconnects, such as conductive vias. The conductive vias may electrically couple different levels of the conductive layers and the conductive pads. The routing layers 114 may be formed by plating or any suitable methods. The routing layers 114 may be formed of a material similar to that of the through vias 106, including copper, silver, gold, the like, an alloy thereof, or a combination thereof.

Afterwards, a plurality of thermal vias 116 are formed in contact with the heat sink 110, in accordance with some embodiments. Then, a plurality of thermal pads 118 may be formed over the thermal vias 116. The thermal vias 116 and the thermal pads 118 may be formed during the formation of the routing layers 114 by plating or any suitable methods. The thermal vias 116 and the thermal pads 118 may be formed of metal, including copper, silver, gold, the like, an alloy thereof, or a combination thereof. The dielectric layers 112, the routing layers 114, the thermal vias 116, and the thermal pads 118 may be referred to as a redistribution layer. The thermal vias 116 and the thermal pads 118 may be thermally coupled to the heat sink 110. The thermal vias 116 and the thermal pads 118 may be connected to ground without electrical signals passing through.

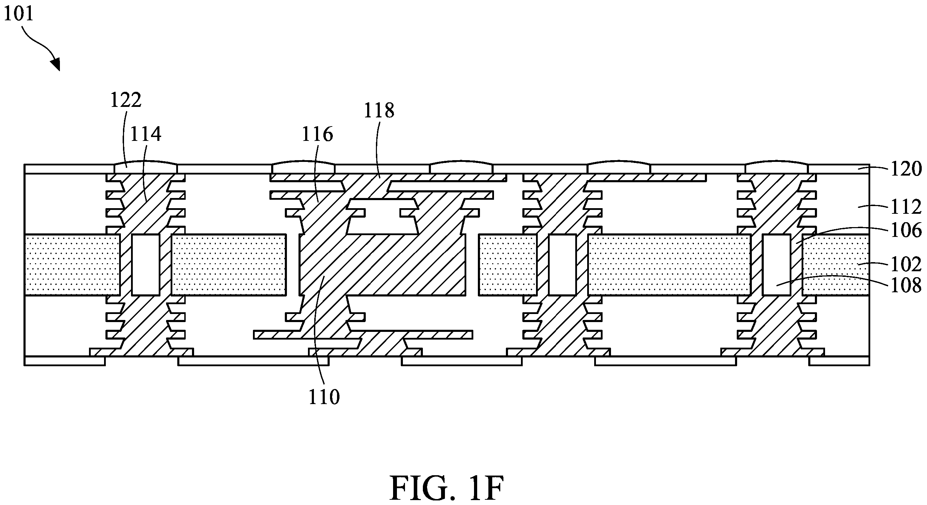

Afterwards, as illustrated in FIG. 1F, a solder resist 120 is formed over the dielectric layers 112 to protect the redistribution layer from external damage, in accordance with some embodiments. A plurality of openings may be formed in the solder resist 120 by a lithography process or any suitable methods to expose the thermal pads 118 and the conductive pads of the routing layers 114.

Then, a plurality of solder connectors 122 may be formed in the openings and in contact with the thermal pads 118 and the conductive pads of the routing layers 114. The solder connectors 122 may include solder balls or other conductive connectors. The solder connectors 122 may be placed in a grid array of rows and columns by a printing process or any suitable methods. A package substrate 101 is formed.

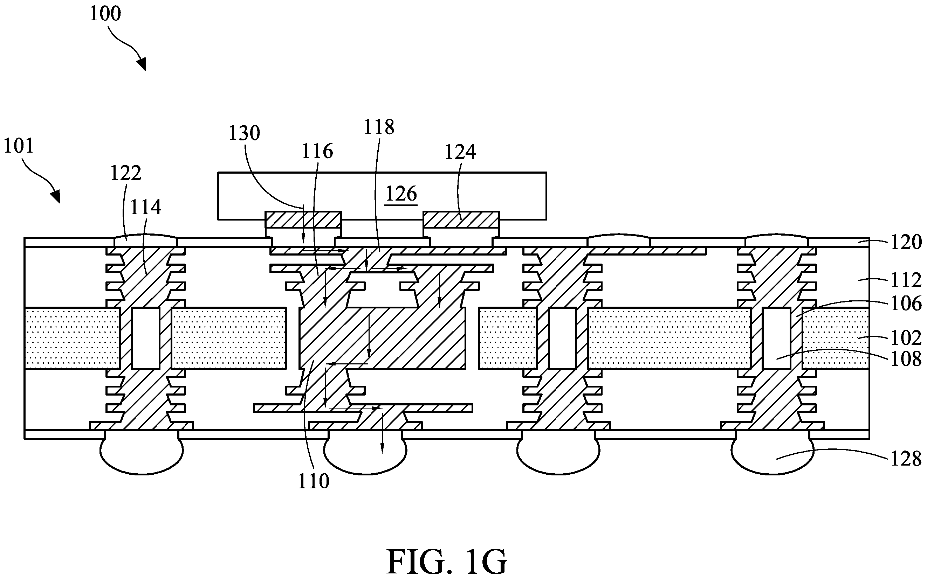

Afterwards, as shown in FIG. 1G, a semiconductor die 126 is disposed over the package substrate 101, in accordance with some embodiments. In some embodiments, the semiconductor die 126 includes a system-on-chip (SoC) die, a logic device, a memory device, a radio frequency (RF) device, the like, or any combination thereof. For example, the semiconductor die 126 may include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or any combination thereof.

It should be noted that one semiconductor die 126 is for illustrative purposes only, and two or more semiconductor dies may be disposed over the package substrate 101. In addition, one or more passive components (such as resistors, capacitors, or inductors) may also be disposed over the package substrate 101.

A plurality of conductive connectors 124 may be formed below the semiconductor die 126 to connect the solder connectors 122. The conductive connectors 124 may include microbumps, controlled collapse chip connection (C4) bumps, conductive pillars, the like, or a combination thereof. The conductive connectors 124 may be formed of metal, such as tungsten, titanium, tantalum, ruthenium, cobalt, copper, aluminum, platinum, tin, silver, gold, the like, an alloy thereof, or a combination thereof.

A plurality of conductive terminals 128 may be disposed on the surface of the package substrate 101 opposite to the semiconductor die 126. A semiconductor package structure 100 is formed. The conductive terminals 128 may include microbumps, controlled collapse chip connection (C4) bumps, solder balls, ball grid array (BGA) balls, the like, or a combination thereof. The conductive terminals 128 may be formed of metal, such as tungsten, titanium, tantalum, ruthenium, cobalt, copper, aluminum, platinum, tin, silver, gold, the like, an alloy thereof, or a combination thereof.

As a result, as indicated by the arrows 130, the heat from the semiconductor die 126 can be transferred to the heat sink 110 through the thermal pads 118 and the thermal vias 116, and can be further transferred to the conductive terminals 128. Since the heat sink 110 is formed of a higher thermal conductivity material than the core structure 102, system thermal budget of the package substrate 101 can be increased. In addition, a quick thermal dissipation path can be provided.

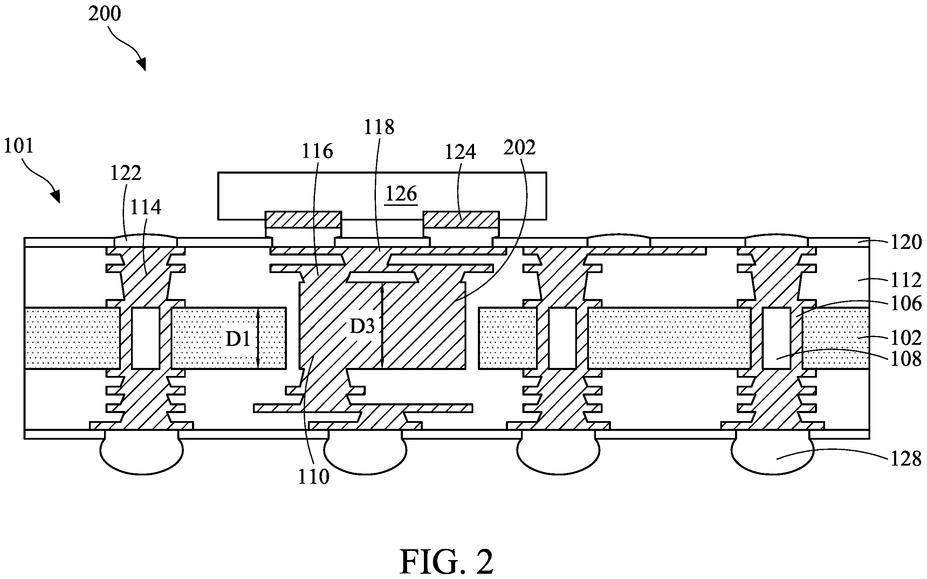

FIG. 2 is a cross-sectional view of a semiconductor package structure 200 in accordance with some embodiments of the present disclosure. It should be noted that the semiconductor package structure 200 may include the same or similar components as that of the semiconductor package structure 100, which is illustrated in FIG. 1G, and for the sake of simplicity, those components will not be discussed in detail again. In the following embodiments, the thickness of the heat sink is greater than the thickness of the core structure.

As illustrated in FIG. 2, a heat sink 202 is embedded in the core structure 102, in accordance with some embodiments. The thickness D3 of the heat sink 202 may be greater than the thickness D1 of the core structure 102 to increase the heat dissipation efficiency. The bottom surface of the heat sink 202 may be substantially aligned with the bottom surface of the core structure 102 due to the process of forming the heat sink 202. The top surface of the heat sink 202 may be higher than the top surface of the core structure 102.

The thickness D3 of the heat sink 202 may be substantially equal to the sum of the thickness D1 of the core structure 102 and the thickness of at least one of the routing layers 114. The top surface of the heat sink 202 may be substantially aligned with an upper layer of the routing layers 114, which helps the subsequent process of forming the redistribution layer.

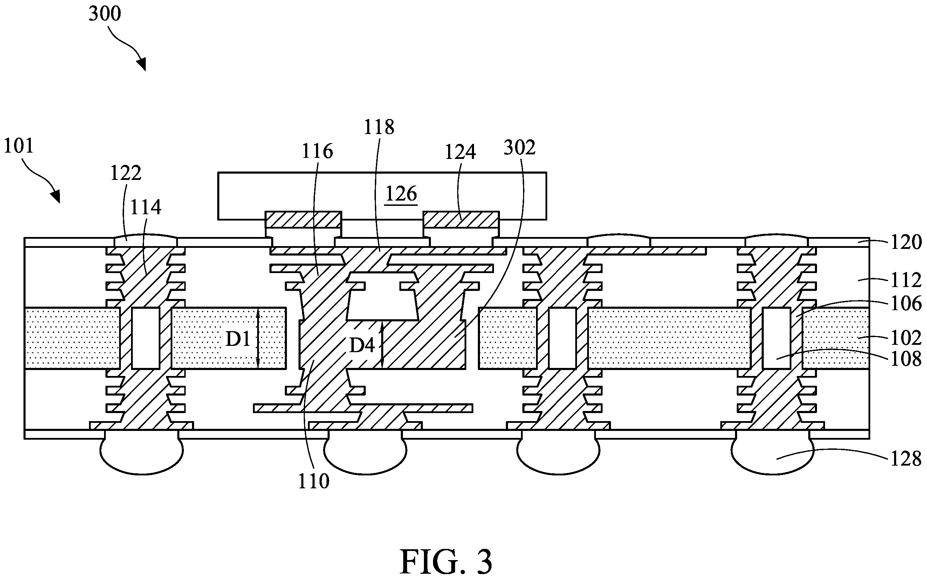

FIG. 3 is a cross-sectional view of a semiconductor package structure 300 in accordance with some embodiments of the present disclosure. It should be noted that the semiconductor package structure 300 may include the same or similar components as that of the semiconductor package structure 100, which is illustrated in FIG. 1G, and for the sake of simplicity, those components will not be discussed in detail again. In the following embodiments, the thickness of the heat sink is less than the thickness of the core structure.

As shown in FIG. 3, a heat sink 302 is embedded in the core structure 102, in accordance with some embodiments. The thickness D4 of the heat sink 302 may be less than the thickness D1 of the core structure 102. The bottom surface of the heat sink 302 may be substantially aligned with the bottom surface of the core structure 102 due to the process of forming the heat sink 302. The top surface of the heat sink 302 may be lower than the top surface of the core structure 102.

The thermal vias 116 in contact with the heat sink 302 may extend into the core structure 102. In some embodiments, as illustrated in FIG. 3, the thickness of the bottommost thermal vias 116 is greater than the thickness of other thermal vias 116. Alternatively, in some other embodiments, additional thermal vias 116 (not illustrated) are embedded in the core structure 102, and the thickness of the bottommost thermal vias 116 is substantially equal to the thickness of other thermal vias 116.

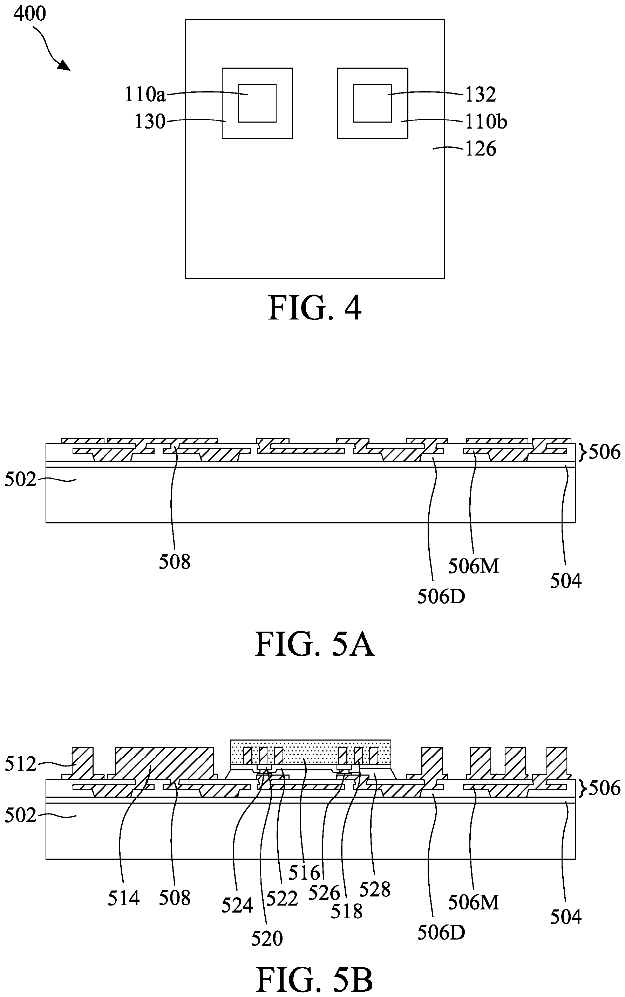

FIG. 4 is a top view of the semiconductor package structure 400, in accordance with some embodiments of the present disclosure. It should be noted that the semiconductor package structure 400 may include the same or similar components as that of the semiconductor package structure 100, which is illustrated in FIG. 1G, and for the sake of simplicity, those components will not be discussed in detail again. The description of the semiconductor package structure 400 may be adopted in any semiconductor package structure of the present disclosure.

As illustrated in FIG. 4, the semiconductor package structure 400 may include heat sinks 110a and 110b vertically overlapped by the semiconductor die 126. The semiconductor die 126 may include hot spots 130 and 132, which may be central processing unit (CPU) cores or the like. The heat sinks 110a and 110b may be disposed below the hot spots 130 and 132, respectively. The heat sinks 110a and 110b may be arranged to be vertically overlapped by the hot spots 130 and 132 to increase heat dissipation efficiency.

In some embodiments, the area of the heat sink 110a is less than the area of the hot spot 130, so that the heat dissipation efficiency can be improved while more routing layers (such as the routing layers 114 in FIG. 1G) can be disposed in the package substrate (such as the package substrate 101 in FIG. 1G). In some embodiments, the area of the heat sink 110b is greater than the area of the hot spot 132, so that the heat dissipation efficiency can be further improved.

FIGs. 5A to 5E are cross-sectional views of various stages of manufacturing a semiconductor package structure 500 in accordance with some embodiments of the present disclosure. It should be noted that the semiconductor package structure 500 may include the same or similar components as that of the semiconductor package structure 100, which is illustrated in FIG. 1G, and for the sake of simplicity, those components will not be discussed in detail again. In the following embodiments, the heat sink is adopted to partially replace a molding material.

As illustrated in FIG. 5A, a first redistribution layer 506 is formed over a carrier substrate 502 through a glue layer 504, in accordance with some embodiments. The carrier substrate 502 may be formed of silicon, glass, ceramic, or any suitable material. The glue layer 504 may be formed of a polymer-based material, and may be removed along with the carrier substrate 502 from the first redistribution layer 506. For example, the glue layer 504 may be formed of a material which loses its adhesive property when heated or exposed to UV lights.

The first redistribution layer 506 may include routing layers 506M disposed in dielectric layers 506D. The dielectric layers 506D may be formed of polymer, including polyimide (PI), polybenzoxazole (PBO), benzocyclobutene (BCB), epoxy, the like, or a combination thereof. Alternatively, the dielectric layers 506D may be formed of silicon oxide, silicon nitride, silicon oxynitride, the like, or a combination thereof. The dielectric layers 506D may be formed by spin coating, chemical vapor deposition (CVD), or another suitable deposition. Then, the dielectric layers 506D may be patterned.

Then, the routing layers 506M may be formed in the dielectric layers 506D by plating, CVD, physical vapor deposition (PVD), or another suitable deposition. The routing layers 506M may include horizontal interconnects, such as conductive layers or conductive pads, and vertical interconnects, such as conductive vias. The conductive vias may electrically couple different levels of the conductive layers and the conductive pads. The routing layers 506M may be formed of metal, including tungsten, titanium, tantalum, ruthenium, cobalt, copper, aluminum, platinum, tin, silver, gold, the like, an alloy thereof, or a combination thereof.

The first redistribution layer 506 may include a plurality of thermal vias 508. The thermal vias 508 may be formed during the formation of the routing layers 506M. The thermal vias 508 may be formed of a material same as or similar to the routing layers 506M, such as metal. The thermal vias 508 may be connected to ground without electrical signals passing through.

Afterwards, as illustrated in FIG. 5B, a plurality of conductive pillars 512 are formed over the first redistribution layer 506 and electrically coupled to the conductive pads of the routing layers 506M, in accordance with some embodiments. The conductive pillars 512 may be formed of metal, such as tungsten, titanium, tantalum, ruthenium, cobalt, copper, aluminum, platinum, tin, silver, gold, the like, an alloy thereof, or a combination thereof. The conductive pillars 512 may be formed by plating, CVD, PVD, or another suitable deposition.

A heat sink 514 is disposed over the first redistribution layer 506 and thermally coupled to the thermal vias 508, in accordance with some embodiments. The heat sink 514 may be formed of metal, such as tungsten, titanium, tantalum, ruthenium, cobalt, copper, aluminum, platinum, tin, silver, gold, the like, an alloy thereof, or a combination thereof. In some embodiments, the heat sink 514 is a preformed metal block and then is attached onto the first redistribution layer 506 through an adhesion layer, including thermal interface material (TIM), Tin (Sn), or any suitable material. In some other embodiments, the heat sink 514 is formed by plating, CVD, PVD, or another suitable deposition, and is formed during the formation of the conductive pillars 512.

Then, a bridge structure 516 is formed over the first redistribution layer 506, in accordance with some embodiments. The bridge structure 516 may be a bridge die and may include a silicon body and a redistribution layer (not illustrated) formed on the silicon body. The redistribution layer may include a connecting structure in one or more dielectric layers to electrically couple two semiconductor dies to each other.

The bridge structure 516 may include an interconnecting structure, such as a plurality of through vias 518. The interconnecting structure in the bridge structure 516 may have other configurations. The through vias 518 may be formed of formed of metal, including tungsten, titanium, tantalum, ruthenium, cobalt, copper, aluminum, platinum, tin, silver, gold, the like, an alloy thereof, or a combination thereof.

A plurality of conductive pads 520 may be formed on the frontside surface of the bridge structure 516 and may be electrically coupled to the through vias 518. The conductive pads 520 may be formed of metal, such as tungsten, titanium, tantalum, ruthenium, cobalt, copper, aluminum, platinum, tin, silver, gold, the like, an alloy thereof, or a combination thereof.

A passivation layer 522 is formed on the frontside surface of the bridge structure 516, in accordance with some embodiments. The passivation layer 522 may cover edge portions of the conductive pads 520 and may partially expose the conductive pads 520. In some embodiments, the passivation layer 522 may include a polymer layer, which may be formed of polyimide (PI), polybenzoxazole (PBO), benzocyclobutene (BCB), epoxy, the like, or a combination thereof. Alternatively, the passivation layer 522 may include a dielectric layer, which may be formed of silicon oxide, silicon nitride, silicon oxynitride, the like, or a combination thereof.

The bridge structure 516 may be electrically coupled to the routing layers 506M through the conductive pads 520, a plurality of conductive connectors 524, and a plurality of solder connectors 526. The solder connectors 526 may include solder balls. The conductive connectors 524 may include microbumps, controlled collapse chip connection (C4) bumps, solder balls, ball grid array (BGA) balls, the like, or a combination thereof. The conductive connectors 524 may be formed of metal, including tungsten, titanium, tantalum, ruthenium, cobalt, copper, aluminum, platinum, tin, silver, gold, the like, an alloy thereof, or a combination thereof. The conductive connectors 524 may be partially surrounded by the passivation layer 522.

An underfill material 528 may be formed between the bridge structure 516 and the first redistribution layer 506, in accordance with some embodiments. The underfill material 528 may surround each of the conductive connectors 524 and the solder connectors 526 to provide structural support. The underfill material 528 may be formed of polymer, including epoxy, polyimide, polybenzoxazole (PBO), the like, or a combination thereof. The underfill material 528 may be dispensed with capillary force, and then may be cured through any suitable curing process.

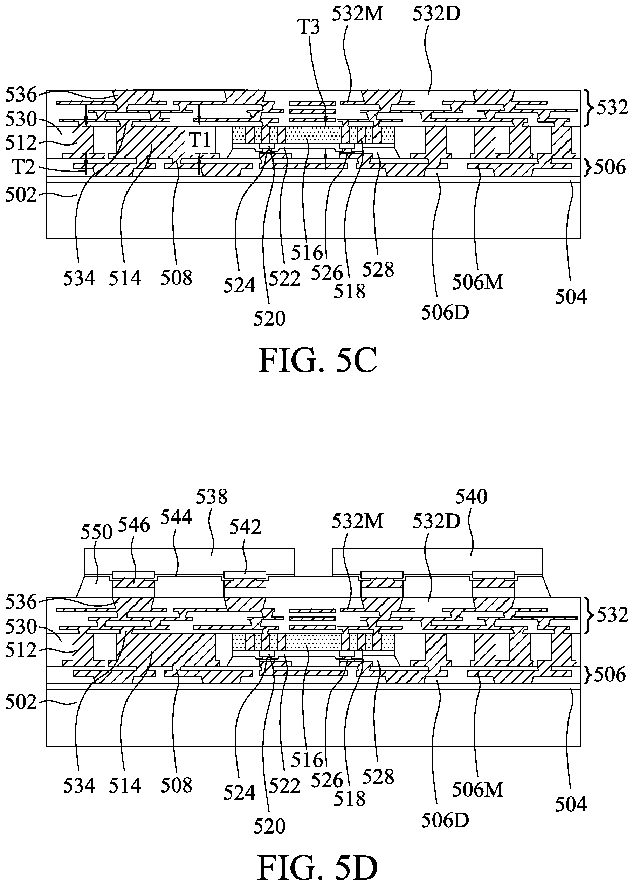

Then, as illustrated in FIG. 5C, a molding material 530 is formed over the first redistribution layer 506, in accordance with some embodiments. The molding material 530 may surround each of the conductive pillars 512, the bridge structure 516, and the heat sink 514. The molding material 530 may protect these components from the environment, thereby protecting them from damage due to stress, chemicals, and moisture. The molding material 530 may be formed of a non-conductive material, including moldable polymer, epoxy, resin, the like, or a combination thereof.

Afterwards, a planarization process is performed on the molding material 530 until the top surfaces of the conductive pillars 512, the heat sink 514, and the through vias 518 are exposed, in accordance with some embodiments. The planarization process may include a chemical mechanical polishing (CMP) process, a mechanical grinding process, the like, or a combination thereof. The top surfaces of the conductive pillars 512, the top surface of the heat sink 514, the top surface of the bridge structure 516, and the top surfaces of the through vias 518 may be substantially coplanar.

As shown in FIG. 5C, in a direction vertical to the top surface of the first redistribution layer 506, the heat sink 514 may have a thickness T1, one of the conductive pillars 512 may have a thickness T2, and the bridge structure 516 may have a thickness T3. The thickness T1 of the heat sink 514 may be substantially equal to the thickness T2 of one of the conductive pillars 512. The thickness T1 of the heat sink 514 may be greater than the thickness T3 of the bridge structure 516. The thickness T2 of one of the conductive pillars 512 may be greater than the thickness T3 of the bridge structure 516.

Then, a second redistribution layer 532 is formed over the bridge structure 516, in accordance with some embodiments. The second redistribution layer 532 may include a routing layers 532M disposed in dielectric layers 532D. The dielectric layers 532D and the routing layers 532M may be similar to the dielectric layers 506D and the routing layers 506M, respectively, and will not be described in detail. The routing layers 532M may be electrically coupled to the routing layers 506M through the conductive pillars 512 and the through vias 518.

The second redistribution layer 532 may include a plurality of thermal vias 534 and thermal pads 536. The thermal vias 534 and thermal pads 536 may be formed during the formation of the routing layers 532M. The thermal vias 534 and thermal pads 536 may be formed of a material same as or similar to the routing layers 532M, such as metal. The thermal vias 534 and thermal pads 536 may be connected to ground without electrical signals passing through.

Then, as illustrated in FIG. 5D, semiconductor dies 538 and 540 are formed over the second redistribution layer 532, in accordance with some embodiments. In some embodiments, the semiconductor dies 538 and 540 each independently includes a system-on-chip (SoC) die, a logic device, a memory device, a radio frequency (RF) device, the like, or any combination thereof. For example, the semiconductor dies 538 and 540 may each include a micro control unit (MCU) die, a microprocessor unit (MPU) die, a power management integrated circuit (PMIC) die, a radio frequency front end (RFFE) die, an accelerated processing unit (APU) die, a central processing unit (CPU) die, a graphics processing unit (GPU) die, an input-output (IO) die, a dynamic random access memory (DRAM) controller, a static random-access memory (SRAM), a high bandwidth memory (HBM), an application processor (AP) die, an application specific integrated circuit (ASIC) die, the like, or any combination thereof. The semiconductor dies 538 and 540 may include the same or different devices.

It should be noted that two semiconductor dies 538 and 540 are for illustrative purposes only, more than two semiconductor dies and/or one or more passive components (such as resistors, capacitors, or inductors) may be disposed over the second redistribution layer 532.

A plurality of conductive pads 542 may be formed on the frontside of the semiconductor dies 538 and 540. A passivation layer 544 may be formed on the frontside of the semiconductor dies 538 and 540. The passivation layer 544 may cover edge portions of the conductive pads 542 and partially expose the conductive pads 542. The conductive pads 542 and the passivation layer 544 may be similar to the conductive pads 520 and the passivation layer 522, respectively, and will not be described in detail.

The semiconductor dies 538 and 540 may be electrically coupled to the routing layers 532M through a plurality of conductive connectors 546. The conductive connectors 546 may include microbumps, controlled collapse chip connection (C4) bumps, solder balls, ball grid array (BGA) balls, the like, or a combination thereof. The conductive connectors 546 may be formed of metal. The conductive connectors 546 may be partially surrounded by the passivation layer 544.

The semiconductor dies 538 and 540 may be arranged on opposite sides of the bridge structure 516. The semiconductor dies 538 and 540 may each partially overlap the bridge structure 516 and may be electrically coupled to each other through the conductive pads 542, the conductive connectors 546, the routing layers 532M, and the bridge structure 516.

An underfill material 550 is formed between the semiconductor dies 538, 540 and the second redistribution layer 532, in accordance with some embodiments. The underfill material 550 may surround each of the conductive connectors 546 to provide structural support. In some embodiments, the underfill material 550 includes a non-conductive film. One underfill material 550 may be disposed below the semiconductor dies 538, 540 as illustrated. Alternatively, two separate underfill materials 550 may be disposed below each of the semiconductor dies 538, 540.

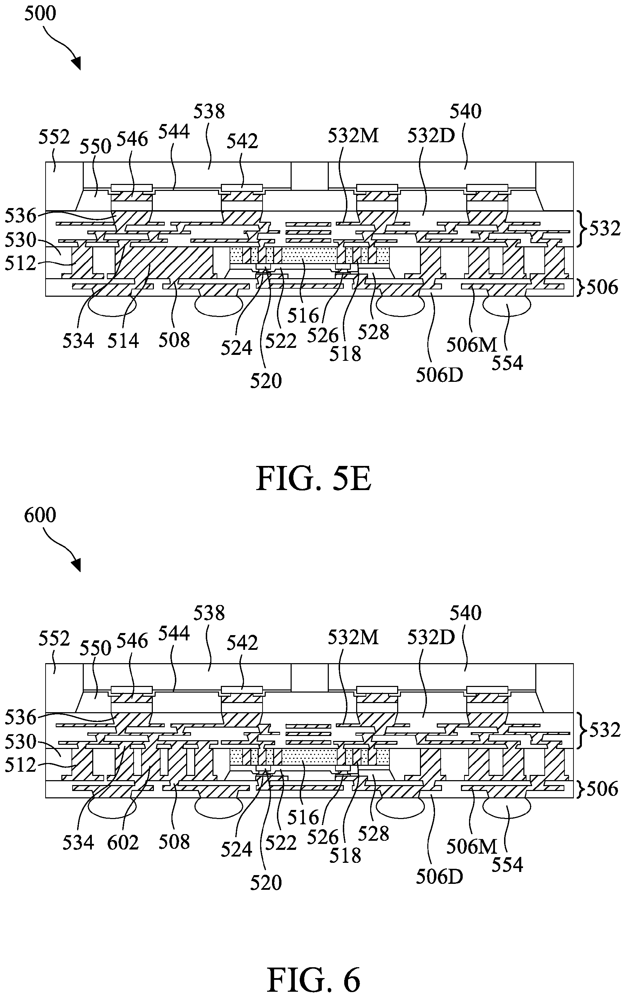

Then, as illustrated in FIG. 5E, a molding material 552 is formed over the second redistribution layer 532, in accordance with some embodiments. The molding material 552 may surround the underfill material 550 and the semiconductor dies 538 and 540. The molding material 552 may protect these components from the environment, thereby preventing damage due to stress, chemicals, and moisture. The molding material 552 may be formed of a non-conductive material, including moldable polymer, epoxy, resin, the like, or a combination thereof.

Then, a planarization process may be performed on the molding material 552 until the top surfaces of the semiconductor dies 538 and 540 are exposed. The planarization process may include a CMP process, a mechanical grinding process, the like, or a combination thereof.

Afterwards, the carrier substrate 502 and the glue layer 504 may be removed by a de-bonding process. In some embodiments, the de-bonding is performed by projecting UV lights on the glue layer 504 or heating the glue layer 504, which causes the glue layer 504 to be decomposed, and hence the carrier substrate 502 is detached from the first redistribution layer 506.

Then, a plurality of conductive terminals 554 are formed below the first redistribution layer 506 and electrically coupled to the routing layers 506M, in accordance with some embodiments. The conductive terminals 554 may include microbumps, controlled collapse chip connection (C4) bumps, solder balls, ball grid array (BGA) balls, the like, or a combination thereof. The conductive terminals 554 may be formed of metal, such as tungsten, titanium, tantalum, ruthenium, cobalt, copper, aluminum, platinum, tin, silver, gold, the like, an alloy thereof, or a combination thereof. A semiconductor package structure 500 is formed.

The semiconductor die 538 may be arranged to vertically overlap the heat sink 514. In particular, the hot spot of the semiconductor die 538 may be arranged to vertically overlap the heat sink 514 to increase heat dissipation efficiency. The heat from the semiconductor die 538 can be transferred to the heat sink 514 through the thermal pads 536 and the thermal vias 534 and 508, and can be further transferred to the conductive terminals 554. Since the heat sink 514 is formed of a higher thermal conductivity material than the molding material 530, system thermal budget of the semiconductor package structure 500 can be increased. In addition, a quick thermal dissipation path can be provided.

Although one heat sink 514 is illustrated in FIG. 5E, the present disclosure is not limited thereto. For example, an additional heat sink may be disposed below the semiconductor die 538 and adjacent to the heat sink 514. Alternatively, an additional heat sink may be disposed below the semiconductor die 540 and vertically overlapped by the semiconductor die 540.

FIG. 6 is a cross-sectional view of a semiconductor package structure 600 in accordance with some embodiments of the present disclosure. It should be noted that the semiconductor package structure 600 may include the same or similar components as that of the semiconductor package structure 500, which is illustrated in FIG. 5E, and for the sake of simplicity, those components will not be discussed in detail again. In the following embodiments, the heat sink is formed of a plurality of metal pillars.

As illustrated in FIG. 6, the semiconductor package structure 600 includes a heat sink 602, which includes a plurality of metal pillars, in accordance with some embodiments. The heat sink 602 may be disposed between the first redistribution layer 506 and the second redistribution layer 532. The heat sink 602 may be formed of metal, such as tungsten, titanium, tantalum, ruthenium, cobalt, copper, aluminum, platinum, tin, silver, gold, the like, an alloy thereof, or a combination thereof.

The heat sink 602 may be thermally coupled to the thermal vias 508 and 534 and thermal pads 536, so that the heat from the semiconductor die 538 can be transferred to the heat sink 602 through the thermal pads 536 and the thermal vias 508 and 534, and can be further transferred to the conductive terminals 554. The heat sink 602 may be formed by plating, CVD, PVD, or another suitable deposition, and may be formed during the formation of the conductive pillars 512.

In summary, the semiconductor package structure according to the present disclosure includes a heat sink to replace semiconductor components which are not formed of good thermal conductivity materials, so that the heat dissipation efficiency can be improved. Therefore, more system thermal budget and a quick thermal dissipation path can be provided.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package structure (100, 200, 300, 400, 500, 600), comprising:
a first redistribution layer (506);
a heat sink (110, 110a, 110b, 202, 302, 514, 602) disposed over the first redistribution layer (506);
a second redistribution layer (532) comprising a first thermal via disposed over the heat sink (110, 110a, 110b, 202, 302, 514, 602); and
a first semiconductor die (126, 538, 540) disposed over the second redistribution layer (532) and thermally coupled to the heat sink (110, 110a, 110b, 202, 302, 514, 602) through the first thermal via.

2. The semiconductor package structure (100, 200, 300) as claimed in claim 1, further comprising:
a package substrate (101) comprising:
the first redistribution layer (506) and the second redistribution layer (532); and
a core structure (102) sandwiched between the first redistribution layer (506) and the second redistribution layer (532),
wherein the heat sink (110, 110a, 110b, 202, 302) is embedded in the core structure (102).

3. The semiconductor package structure (100, 200, 300) as claimed in claim 2, wherein a bottom surface of the heat sink (110, 110a, 110b, 202, 302) is substantially aligned with a bottom surface of the core structure (102).

4. The semiconductor package structure (100, 200, 300) as claimed in claim 3, wherein a top surface of the heat sink (110, 110a, 110b, 202, 302) is substantially aligned with a top surface of the core structure (102).

5. The semiconductor package structure (100, 200, 300) as claimed in claim 3, wherein a top surface of the heat sink (110, 110a, 110b, 202, 302) is above a top surface of the core structure (102).

6. The semiconductor package structure (100, 200, 300) as claimed in claim 3, wherein a top surface of the heat sink (110, 110a, 110b, 202, 302) is below a top surface of the core structure (102).

7. The semiconductor package structure (100, 200, 300, 400) as claimed in claim 2, wherein the package substrate (101) further comprises:
a dielectric layer surrounding the first thermal via and extending between the heat sink (110, 110a, 110b, 202, 302) and the core structure (102); and
a through via embedded in the core structure (102) and electrically coupled to a routing layer of the second redistribution layer (532).

8. The semiconductor package structure (100, 200, 300, 400, 500, 600) as claimed in claim 1, wherein the heat sink (110, 110a, 110b, 202, 302, 514, 602) is formed of metal.

9. The semiconductor package structure (500) as claimed in claim 1, wherein a hot spot (130) of the first semiconductor die (538) vertically overlaps the heat sink (514).

10. The semiconductor package structure (500) as claimed in claim 1, further comprising:
a bridge structure (516) disposed between the first redistribution layer (506) and the second redistribution layer (532); and
a second semiconductor die (540) disposed over the second redistribution layer (532) and electrically coupled to the first semiconductor die (538) through the bridge structure (516).

11. The semiconductor package structure (500) as claimed in claim 1, further comprising:
a plurality of conductive pillars (512) electrically coupling the first redistribution layer (506) to the second redistribution layer (532); and
a molding material (530, 552) surrounding the heat sink (110, 110a, 110b, 514), the bridge structure (516), and the plurality of conductive pillars (512).

12. The semiconductor package structure (500) as claimed in claim 11, wherein a thickness of the heat sink (514) is substantially equal to a thickness of the plurality of conductive pillars (512) in a direction vertical to the first redistribution layer (506).

13. The semiconductor package structure (500) as claimed in claim 11, wherein the thickness of the heat sink (514) is greater than a thickness of the bridge structure (516) in the direction vertical to the first redistribution layer (506).

14. The semiconductor package structure (100, 200, 300, 400, 500, 600) as claimed in claim 1, wherein the heat sink (110, 110a, 110b, 202, 302, 514, 602) comprises a metal block or a plurality of metal pillars.

15. The semiconductor package structure (100, 200, 300, 400, 500, 600) as claimed in claim 1, further comprising:
a conductive terminal disposed below the first redistribution layer (506),
wherein the first redistribution layer (506) comprises a second thermal via thermally coupling the heat sink (110, 110a, 110b, 202, 302, 514, 602) to the conductive terminal.
